# EUROPÄISCHE PATENTSCHRIFT

(11) **EP 1 939 987 B1**
(45) Veröffentlichungstag und Bekanntmachung des Hinweises auf die Patenterteilung: **10.07.2013**
(21) Anmeldenummer: 07122772.2
(22) Anmeldetag: 10.12.2007
(51) Int. Cl.: H01R 4/24

(54) **Kontaktvorrichtung**
Contact device
Dispositif de contact

(30) Priorität: 29.12.2006 DE 102006062597; 29.11.2007 DE 102007057504
(43) Veröffentlichungstag der Anmeldung: 02.07.2008
(73) Patentinhaber: ROBERT BOSCH GMBH, 70442 Stuttgart (DE)
(72) Erfinder: Kimmich, Peter, 71101 Schoeneich (DE)

(56) Entgegenhaltungen:
- WO-A2-00/42679
- FR-A1- 2 550 683

## Beschreibung

Die Erfindung betrifft eine Kontaktvorrichtung zum elektrischen Kontaktieren von mindestens einem ersten Leiter mit mindestens einem zweiten Leiter, wobei der erste Leiter in einem Schlitzwände aufweisenden Schlitz eines Basisteils angeordnet ist und der zweite Leiter zur Kontaktierung des ersten Leiters in den Schlitz zur Erzeugung einer Schneidklemmverbindung eingedrückt ist.

### Stand der Technik

Kontaktvorrichtungen zum elektrischen Kontaktieren eines ersten Leiters mit einem zweiten Leiter, bei denen der erste Leiter in einem Schlitzwände aufweisenden Schlitz eines Basisteils angeordnet ist, sind bekannt. Beispielswiese ist aus der WO 00/42679 eine Leiterplatte bekannt, bei der Leiterbahnen im Randbereich der Leiterplatte Verbreiterungen aufweisen, die einen randoffenen Schlitz umgreifen, der in die Leiterplatte eingebracht ist, und wobei Durchkontaktierungen zwischen einer Oberseite und einer Unterseite dieser Leiterplatte an den Leiterbahnen angeordnet sind. Ein isolierter Draht wird zur Kontaktierung mit den Leiterbahnen der Leiterplatte schräg in diesen Schlitz eingebracht, dergestalt, dass scharfkantige Kanten der Durchkontaktierungen die Isolierung des Drahtes durchschneiden und den schräg eingebrachten Draht mit einer Klemmkraft beaufschlagen, so dass ein elektrischer Kontakt zwischen den Durchkontaktierungen und dem Draht mithin also auch zwischen dem Draht und den Leiterplatten, die die Durchkontaktierungen aufweisen, hergestellt wird. Hierbei ist nachteilig, dass der Draht in einer mehr oder minder schrägen Ausrichtung relativ zur Leiterplatte eingebracht werden muss, um die gewünschte Wirkung der Durchkontaktierungen in Bezug auf die Isolierung und den Draht zu erzielen. Weiter ist nachteilig, dass diese Art der Kontaktierung in der Anwendung eher unflexibel ist.

Aus der FR 2550683 A1 ist eine Leiterplatte bekannt, die an einer Stirnseite sich verengende, schlitzförmige Einkerbungen aufweist. In diese Einkerbungen können die abisolierten Enden von Kabeln eingeführt und verlötet werden. Dabei üben die Einkerbungen durch Ihre Form eine gewisse Klemmwirkung auf die Kabelenden aus. Auf der Leitplatte sind Leiterbahnen vorhanden, die mit den Einkerbungen in elektrischem Kontakt stehen.

Aufgabe der Erfindung ist es, eine Kontaktvorrichtung zum elektrischen Kontaktieren mindestens eines ersten Leiters der gattungsgemäßen Art mit einem zweiten Leiter bereitzustellen, der die diese Nachteile vermeidet und eine flexible, dauerbetriebssichere, einfach zu handhabende und preisgünstige Kontaktierung ermöglicht.

### Offenbarung der Erfindung

Hierzu wird eine Kontaktvorrichtung zum elektrischen Kontaktieren von mindestens einem ersten Leiter mit mindestens einem zweiten Leiter vorgeschlagen, wobei der erste Leiter in einem Schlitzwände aufweisenden Schlitz eines Basisteils angeordnet ist und der zweite Leiter zur Kontaktierung des ersten Leiters in den Schlitz zur Erzeugung einer Schneidklemmverbindung eingedrückt ist. Hierbei ist vorgesehen, dass das Basisteil benachbart zum Schlitz mindestens einen Durchbruch zum federnden Nachgeben der zugeordneten Schlitzwand des Schlitzes aufweist. Der erste Leiter ist demzufolge in dem Schlitz des Basisteils angeordnet, wobei der Schlitz Schlitzwände aufweist. Die Schneidklemmverbindung und damit die Kontaktierung des zweiten Leiters mit dem ersten Leiters wird im Bereich des Schlitzes zwischen dem zweiten Leiter und den Schlitzwänden bewirkt. Dies geschieht im weitesten Sinne nach dem Prinzip der aus dem Stand der Technik bekannten Schneidklemmverbindung, dergestalt, dass der zweite Leiter klemmend zwischen den Schlitzwänden gehalten ist. Soweit dieser eine Isolierung aufweist, kann diese durch Bereiche der Schlitzwände durchtrennt werden. Die Ausrichtung der Durchmesser beziehungsweise der Querschnitte des zweiten Leiters relativ zu den Dimensionen des Schlitzes, insbesondere zum Abstand der Schlitzwände zueinander im Sinne der lichten Weiten des Schlitzes werden hierbei so aufeinander abgestimmt, dass der Schlitz geringfügig enger ist als der Durchmesser des Drahtes beziehungsweise dessen in dieser Richtung wirkender Querschnittsbereich. Auf diese Weise wird ein Presssitz beziehungsweise Klemmsitz des zweiten Leiters im Schlitz bewirkt. Anders als im Stand der Technik wird die hierbei erzielte Klemmwirkung nicht ausschließlich durch eine Nachgiebigkeit des Drahtes beziehungsweise im Bereich der Einbringung durch das Basisteil erzielt, sondern durch ein federndes Nachgeben der zugeordneten Schlitzwand des Schlitzes, in deren Nachbarschaft ein Durchbruch in das Basisteil eingebracht ist. Ein Durchbruch ist hierbei beispielsweise eine Bohrung, die in der Nachbarschaft des Schlitzes das Basisteil durchgreift. Durch die Ausdehnung des Durchbruchs und seine Anordnung relativ zum Schlitz lässt sich das federnde Nachgeben über die hierdurch bewirkte Federkraft des Materials des Basisteils, das zwischen Schlitz und Durchbruch besteht, den Anforderungen entsprechend einstellen. Hierbei ist nicht erforderlich, dass der Durchbruch über die volle Längserstreckung des Schlitzes geht; es ist vielmehr auch möglich, dass der Durchbruch beispielsweise in Form einer Bohrung oder in Form einer ovalen, entlang des Schlitzes längserstreckten Ausnehmung in das Basisteil eingebracht ist. Es ergibt sich hierbei die Federwirkung insbesondere unmittelbar benachbart zum Durchbruch, abgeschwächt oder auch bis auf null reduziert in dem Durchbruch entfernter gelegenen Bereichen des Schlitzes. Es ist demzufolge möglich, den zweiten Leiter beispielsweise mit strengem Presssitz einzuführen, um ihn dann in seiner Einbauendlage mit einer durch Ausdehnung und Anordnung des Durchbruchs definierten Federkraft federnd zu halten. Anders als im Stand der Technik kann sich die so bewirkte Kontaktierung nicht lösen, beispielsweise durch Fließen des Materials nach Bewirkung der Kontaktierung, vielmehr wird durch das federnde Nachgeben der dem Durchbruch zugeordneten Schlitzwand in gewisser Weise ein Nachstellen der Kontaktierung durch die Federkraftbeaufschlagung und damit eine dauerhafte, kontaktsichere Kontaktierung bewirkt.

In einer weiteren Ausführungsform ist der Durchbruch ein schlitzförmiger Durchbruch. Ein schlitzförmiger Durchbruch erlaubt die Ausgestaltung relativ großer, federnd nachgebender Bereiche der jeweils zugeordneten Schlitzwand, insbesondere über deren Längserstreckung.

In einer bevorzugten Ausführungsform ist der Schlitz ein randoffener Schlitz. In dieser Ausführungsform lässt sich der zweite Leiter in die Kontaktvorrichtung einfach einschieben, da der Schlitz am randoffenen Ende leicht und relativ weit nachgiebt. Dies erlaubt insbesondere eine sehr einfache Kontaktierung beispielsweise im Zuge einer Montage des Basisteils beispielsweise in einem zugehörigen Gehäuse. Insbesondere erlaubt dies auch die Kontaktierung mehrerer zweiter Leiter in einem Arbeitsvorgang und in einem Zuge, durch bloßes Überschieben des Basisteils über in entsprechendem Abstand angeordnete zweite Leiter, wobei diese zweiten Leiter in die jeweils hierfür vorgesehenen randoffenen Schlitze eingeführt werden.

In einer weiteren bevorzugten Ausführungsform ist der Durchbruch ein geschlossener oder ein randoffener Durchbruch. Bei geschlossenen Durchbrüchen lassen sich, wie bereits oben beschrieben, bestimmte Bereiche des federnden Nachgebens insbesondere in Bezug auf die Axialerstreckung des Schlitzes an gewünschten Positionen leicht und definiert einstellen. Bei randoffenen Durchbrüchen wird gewissermaßen eine Ausbildung von federnd nachgebenden Zungen aus dem Material des Basisteils bewirkt, wobei diese Zunge einerseits vom Schlitz und andererseits vom randoffenen Durchbruch begrenzt werden. Dies erlaubt ein ganz besonders einfaches Einführen auch von durchmesserstärkeren zweiten Leitern in den Schlitz, und insbesondere eine Anwendung mit unterschiedlich starken zweiten Leitern, dergestalt, dass deren Durchmesser nicht ganz exakt auf die lichte Weite des Schlitzes abgestimmt sein muss, da die federnd nachgebende Zunge die Aufnahme von zweiten Leitern innerhalb einer gewissen Toleranzbreite, also von unterschiedlichen Durchmessern um einen Nenndurchmesser herum, gestattet. Hiermit kann insbesondere Fertigungstoleranzen und Serienstreuungen Rechnung getragen werden.

In einer besonders bevorzugten Ausführungsform ist das Basisteil eine Leiterplatte. Gerade in diesem Anwendungsbereich der Leiterplattenkontaktierung lässt sich auf diese Weise eine sehr einfache, günstige und dauerhaft betriebssichere Kontaktvorrichtung bewirken.

Bevorzugt ist der zweite Leiter ein Draht, insbesondere Volldraht oder eine Litze, wie bereits vorstehend beschrieben.

In einer anderen bevorzugten Ausführungsform ist der erste Leiter eine Durchkontaktierung des Schlitzes. Hiermit ist gemeint, dass über die Stärke des Basismaterials erstreckt, also Oberseite und Unterseite verbindend, die Durchkontaktierung eingebracht ist und hierbei elektrisch mit den auf dem Basisteil angeordneten weiteren Leitern verbunden ist, die mit dem zweiten Leiter kontaktiert werden sollen. Durchkontaktierungen sind einfach und preisgünstig herzustellen.

In einer weiteren, besonders bevorzugten Ausführungsform sind beidseitig benachbart zum Schlitz Durchbrüche angeordnet. Insbesondere als randoffene Durchbrüche werden beidseitig des Schlitzes federnd nachgebende Zungen ausgebildet, so dass eine Kontaktvorrichtung mit relativ breitem Anwendungsbereich für unterschiedliche Stärken des zweiten Leiters mit sehr sicherer Kontaktgabe bereitgestellt wird.

In einer weiteren Ausführungsform weist der Schlitz einen Schlitzeingang auf, der als Schlitzverengung zur Erzeugung einer Einführhilfe ausgebildet ist. Der Schlitz weist demzufolge nicht durchgehend seine für die Kontaktierung erforderliche lichte Weite auf, sondern vergrößert in eine Richtung die lichte Weite, um eine Einführhilfe auszubilden. In diese kann der zweite Leiter mit Spiel zu den Seitenwänden eingebracht werden, um dann bei Einführung in die dem Schlitz eigentlich zugehörige lichte Weite der Kontaktierung zugeführt zu werden. Dies vereinfacht die Handhabung beträchtlich. Insbesondere bei der Ausführung des Schlitzes als randoffener Schlitz lässt sich so von außerhalb des Basisteils, nämlich seitlich zugeführt, der zweite Leiter sehr leicht und mit einer insbesondere für sehr schnelle und automatisierte Fertigung geeigneten Lagetoleranz relativ zum Schlitz einbringen.

In einer weiteren bevorzugten Ausführungsform ist der Draht ein isolierter Draht. Die Isolierung lässt sich beispielsweise durch die Durchkontaktierungen durchtrennen. So wird eine einwandfreie Kontaktgabe bei ansonsten gegebener Isolierung bewirkt.

In einer weiteren, besonders bevorzugten Ausführungsform weist der Schlitz mindestens eine Abisolierstufe auf. Hiermit ist gemeint, dass der Schlitz, beispielsweise im Bereich der Einführhilfe, eine Stufe, Kante oder Scharte aufweist, die die Isolierung des zweiten Leiters während des Einführens des zweiten Leiters in den Schlitz durchtrennt oder verdrängt, so dass der Leiter zum Zwecke der Kontaktierung im Schlitz an dieser Stelle freiliegt.

In einer weiteren bevorzugten Ausführungsform weist die Kontaktvorrichtung eine den zweiten Leiter aufnehmende Leiterfixierung auf. Mit Leiterfixierung ist eine solche Vorrichtung oder Anordnung gemeint, die den zweiten Leiter in einer bestimmten, gewünschten Lage hält, insbesondere zum Zwecke und/oder während des Kontaktiervorgangs. Es ist hierbei auch vorgesehen, dass der Leiter dauerhaft, insbesondere nach Bewirken der Kontaktierung, von der Leiterfixierung gehalten wird. Die Leiterfixierung dient hierbei insbesondere der Unterdrückung von mechanischen Einflüssen auf die Kontaktstelle, die in ungünstigen Fällen zu unerwünschten Funktionsbeeinträchtigungen führen könnten. Die Leiterfixierung kann aber auch lediglich als eine Art Handhabungshilfe oder Montagehilfe, insbesondere während des automatisierten Kontaktiervorgangs, ausgebildet sein, durch die der zweite Leiter während des Kontaktiervorgangs in der zum Zwecke der Kontaktierung erforderlichen oder gewünschten Lage gehalten und nach bewirkter Kontaktierung freigegeben wird.

In einer besonders bevorzugten Ausführungsform ist die Leiterfixierung als Gehäuse einer elektrischen/elektronischen Einrichtung ausgebildet. Der zweite Leiter wird hierbei also in zumindest einen Bereich des Gehäuses eingebracht, wobei sich die elektrische Kontaktierung beispielsweise dadurch herstellen lässt, dass nach Einbringung des zweiten Leiters in den Bereich des Gehäuses beispielsweise die die Schlitze aufweisende Leiterplatte so eingeschoben wird, dass die Schlitze die derart gehaltenen zweiten Leiter umgreifen, die zweiten Leiter demzufolge in die Schlitze der hier eingeschobenen Leiterplatte eingedrückt und dort in der gewünschten Einbaulage kontaktiert gehalten werden.

In einer weiteren Ausführungsform ist das Basisteil ein Kontaktvermittlungsteil. Das Basisteil, das den ersten Leiter aufweist, ist hierbei als Kontaktvermittlungsteil ausgebildet, also im weitesten Sinne als eine Art Adapterstück. Insbesondere ist hierbei vorgesehen, dass das Kontaktvermittlungsteil seinerseits weitere Kontaktstellen aufweist, um seinerseits an anderer Stelle mit weiteren, zu kontaktierenden Bauteilen elektrisch verbunden zu werden. Beispielsweise kann das Kontaktvermittlungsteil einseitig eine Aufnahme für den zweiten Leiter, beispielsweise einen Draht oder eine Litze, aufweisen, der insbesondere in einer der vorstehend beschriebenen Ausführungsformen ausgebildet ist, und auf der beispielsweise gegenüberliegenden Seite eine Vorrichtung, die die Kontaktierung beispielsweise einer Leiterplatte oder eines elektrischen oder elektronischen Bauelementes erlaubt. Insbesondere kann das Kontaktvermittlungsteil als Zusatzteil beispielsweise für elektrische Maschinen wie Generatoren oder Motoren ausgebildet sein, der einfache Kontaktierung mit dem zweiten Leiter durch das Kontaktvermittlungsteil ermöglicht wird.

In einer weiteren bevorzugten Ausführungsform ist das Basisteil ein Aufschiebekontaktmittel. Hiermit ist gemeint, dass das Basisteil, insbesondere in der Ausführungsform als Kontaktvermittlungsteil, mit dem weiteren Bauteil im Wege eines Aufschiebens kontaktiert wird, beispielsweise mit einer Leiterplatte und deren Leiterbahnen. Das Aufschiebekontaktmittel weist hierzu beispielsweise den beschriebenen Schlitz zur Aufnahme des zweiten Leiters auf, insbesondere eines Drahts oder einer Litze, und beispielsweise dem Schlitz gegenüberliegend, also auf der dem Schlitz abgewandten Seite des Aufschiebekontaktmittels, einen beispielsweise quer oder im Wesentlichen quer liegenden Aufschiebeschlitz, mittels dessen das Aufschiebekontaktmittel über beispielsweise die Leiterplatte geschoben und gefügt wird, wobei der erste Leiter, der im Schlitz ausgebildet ist, mit einem weiteren Leiter im Aufschiebeschlitz in elektrischem Kontakt steht, so dass zwischen dem Schlitz und dem Aufschiebeschlitz eine elektrische Verbindung besteht. Der in den Schlitz eingebrachte, zweite Leiter wird folglich über den Aufschiebeschlitz des Aufschiebekontaktmittels mit dem weiteren Bauteil kontaktiert. Selbstverständlich kann das Aufschiebekontaktmittel sämtliche im Stand der Technik gebräuchliche Arretiermittel wie beispielsweise Rastnasen et cetera aufweisen, um ein unerwünschtes Abgleiten vom dritten Bauteil zu vermeiden.

Weitere Ausführungsformen ergeben sich aus den Unteransprüchen und aus Kombinationen derselben.

Die Erfindung wird nachfolgend anhand eines Ausführungsbeispiels näher erläutert, ohne jedoch hierauf beschränkt zu sein.

### Kurze Beschreibung der Zeichnungen

Die Erfindung wird nachfolgend anhand von Ausführungsbeispielen näher erläutert, ohne jedoch hierauf beschränkt zu sein.

### Es zeigen

- Figur 1: eine teilperspektivische, schematische Darstellung der Kontaktvorrichtung;
- Figur 2: einen Querschnitt durch die Kontaktvorrichtung;
- Figur 3: eine Ausführungsform der Kontaktvorrichtung mit Abisolierstufe und
- Figur 4: eine Ausführungsform der Kontaktvorrichtung mit separatem Basisteil.

### Ausführungsform(en) der Erfindung

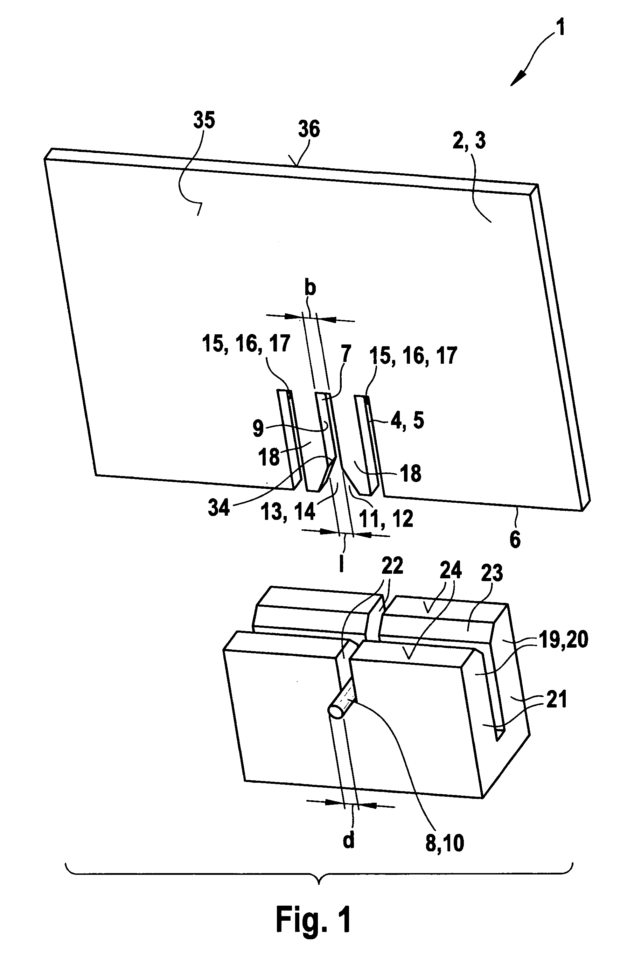

Figur 1 zeigt eine Kontaktvorrichtung 1 mit einem Basisteil 2, das von einer elektrischen Leiterplatte 3 gebildet ist und das einen Schlitz 4 aufweist, der als randoffener Schlitz 5 an einer Längsseite 6 des Basisteils 2 ausgebildet ist, und der einen ersten Leiter 7 zur Kontaktierung eines zweiten Leiters 8 aufweist, wobei der erste Leiter 7 als Durchkontaktierung 34 von Oberseite 35 und Unterseite 36 der Leiterplatte 3 an sich gegenüberliegenden Schlitzwänden 9 des Schlitzes 4 ausgebildet ist, und wobei der Schlitz 4 die Schlitzbreite b aufweist. Die Schlitzbreite b ist als lichte Weite I des Schlitzes 4 zwischen seinen Schlitzwänden 9 zu verstehen. Der zweite Leiter 8 ist ein Draht 10. Dieser weist einen Durchmesser d auf, wobei zur Bewirkung einer Schneidklemmverbindung des zweiten Leiters 8 mit dem ersten Leiter 7 im Schlitz 4 der Durchmesser d des zweiten Leiters 8 gleich groß oder geringfügig größer als die Schlitzbreite b ist. Zum vereinfachten Einführen des zweiten Leiters 8 in den Schlitz 4 ist im Bereich einer Randöffnung 11 des als randoffener Schlitz 5 ausgebildeten Schlitzes 4 eine Einführhilfe 12 ausgebildet, die durch graduelle Vergrößerung der lichten Weite I des Schlitzes 4 bewirkt wird, je näher die Randöffnung 11 ist. Unmittelbar an der Randöffnung 11 ist die lichte Weite I folglich größer als von der Randöffnung entfernt beziehungsweise im Bereich des Schlitzes 4 mit seinen im Wesentlichen parallelen Schlitzwänden 9. Die Einführhilfe 12 bildet damit im Wesentlichen einen Trichter 13, nämlich einen Einführtrichter 14, der sich von ursprünglich großer Weite um so weiter verengt, je weiter er der Längsseite 6 des Basisteils 2 entfernt ist, bis er letztlich die Schlitzbreite b erreicht. Dies dient dem vereinfachten Einführen des zweiten Leiters 8 in den Schlitz 4 zur Kontaktierung mit dem ersten Leiter 7. Links und rechts benachbart zum Schlitz 4 sind zu diesem parallele Durchbrüche 15 als randoffene Durchbrüche 16 eingebracht, die in etwa dieselbe Längserstreckung wie der Schlitz 4 aufweisen und zu derselben Längsseite 6 hin randoffen ausgebildet sind. Hierdurch bilden sich zwischen dem Schlitz 4 und den Durchbrüchen 15, die schlitzförmige Durchbrüche 17 sind, federnd nachgebende Zungen 18 am Basisteil 2 aus, die den Schlitz 4 umgreifen. Die Zungen 18 bewirken ein federndes Nachgeben bei Einführen des zweiten Leiters 8. Sie bewirken bei geeigneter Wahl des Durchmessers d des zweiten Leiters 8 relativ zur Schlitzbreite b des Schlitzes 4 einen satt klemmenden Presssitz des zweiten Leiters 8 am ersten Leiter 7, der zwischen den Schlitzwänden 9 des Schlitzes 4 bewirkt wird. Zur vereinfachten Kontaktierung des zweiten Leiters 8 mit dem an den Schlitzwänden 9 ausgebildeten ersten Leiter 7 ist eine Leiterfixierung 19 vorgesehen, die als Gehäuse 20 einer nicht dargestellten elektrischen oder elektronischen Einrichtung ausgebildet ist. Hierzu sind zwei Gehäusewände 21 vorgesehen, die jeweils im Wesentlichen parallel des Basisteils 2, insbesondere der Leiterplatte 3, verlaufen und die jeweils eine im Wesentlichen parallel dem Schlitz 4 verlaufende Halteschlitzung 22 aufweisen. In die Halteschlitzung 22 wird der zweite Leiter 8 eingebracht, wobei die Halteschlitzung 22 gegenüber dem Durchmesser d des zweiten Leiters 8 bevorzugt vergrößert ist, sodass ein festes Klemmen nicht erfolgt. Die Leiterplatte 3 wird mit dem Schlitz 4 über den in der Halteschlitzung 22 gehaltenen zweiten Leiter 8 geschoben, also die Leiterplatte 3 zwischen die beiden Gehäusewände 21 geschoben, beispielsweise gefügt. Hierbei wird der zweite Leiter 8 in den Bereich des Schlitzes 4 über die Einführhilfe 12 eingeführt und dort mit dem an den Schlitzwänden 9 ausgebildeten ersten Leiter 7 elektrisch kontaktiert. Die Zungen 18 geben hierbei federnd nach, so dass ein satter Presssitz des zweiten Leiters 8 am ersten Leiter 7 bewirkt ist. Gleichzeitig kann der Abstand der Gehäusewände 21 so bemessen sein, dass sie die Leiterplatte 3 zwischen sich klemmend aufnehmen. Auf diese Weise wird eine sehr einfache Kontaktierung und gleichzeitig Halterung der Leiterplatte 3 bewirkt. Quer zur Einführhilfe 12 weist die Leiterfixierung 19 hierzu eine Fügehilfe 23 auf, die als abgeschrägte Stirnflächen 24 der Leiterfixierung 19 ausgestaltet sind und in etwa quer zur Einführhilfe 12 liegen; die Fügehilfe 23 erlaubt ein leichtes Fügen des Basisteils 2 in die Leiterfixierung 19, insbesondere zwischen die Gehäusewände 21. Selbstverständlich kann das Basisteil 2, insbesondere als Leiterplatte 3, eine Vielzahl von Schlitzen 4 aufweisen, ebenso wie das Gehäuse 20 beziehungsweise die Leiterfixierung 19 eine Vielzahl von zweiten Leitern 8, insbesondere in einer Vielzahl von Halteschlitzungen 22, aufweisen kann.

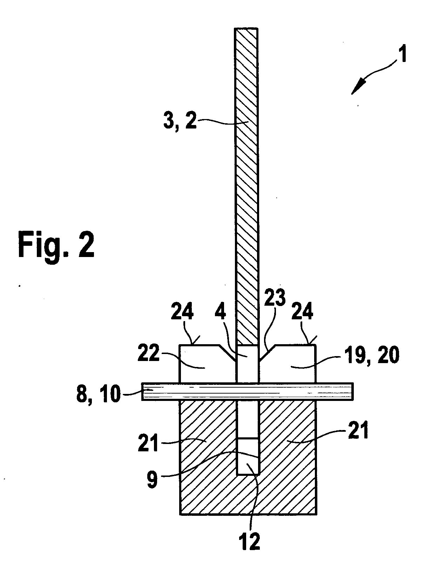

Figur 2 zeigt einen Querschnitt durch die Kontaktvorrichtung 1, mit dem als Leiterplatte 3 ausgebildeten Basisteil 2, das in die Leiterfixierung 19, nämlich in Gehäusewände 21 eingebracht ist, die die Halteschlitzung 22 für den zweiten Leiter 8, nämlich den Draht 10 aufweist. Die Leiterplatte 3 ist mit dem Schlitz 4 über den zweiten Leiter 8 gefügt worden, wobei die Einführhilfe 12 Lagetoleranzen der beiden Leiter 7, 8 beim Einführen beziehungsweise Fügen ausgleicht. Im Bereich der Schlitzwände 9 wird der zweite Leiter 8 klemmend beaufschlagt und die Kontaktierung somit herbeigeführt. Quer zur Einführhilfe 12 weist die Leiterfixierung 19 die Fügehilfe 23 auf, die als abgeschrägte Stirnflächen 24 der Leiterfixierung 19 ausgestaltet sind und in etwa quer zur Einführhilfe 12 liegen; diese erlaubt ein leichtes Fügen des Basisteils 2 in die Leiterfixierung 19, insbesondere zwischen die Gehäusewände 21. Die Leiterfixierung 19 kann selbstverständlich auch unabhängig von einem Gehäuse als eigenständiges Bauteil oder aber an einem Gehäuse ausgebildet sein.

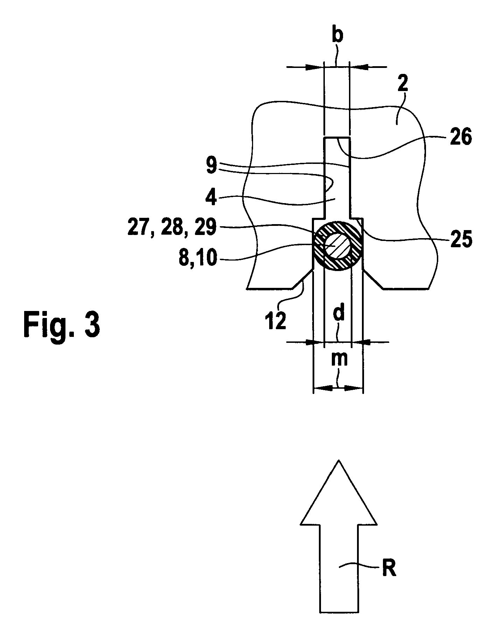

Figur 3 zeigt abschnittsweise das Basisteil 2 mit der Einführhilfe 12 und mit einer zusätzlichen Abisolierstufe 25 am Schlitz 4. Die Abisolierstufe 25 ist derart ausgebildet, dass die Schlitzbreite b in Richtung der Einführhilfe 12, von einer Schlitzendwand 26 aus betrachtet, noch einmal stufig vergrößert ist, und zwar über den Durchmesser d des zweiten Leiters 8 hinaus. Der zweite Leiter 8 ist vorliegend von einer Isolierung 27 umgeben, beispielsweise von einem Mantel 28.Hierdurch ergibt sich ein Mantelaußendurchmesser m, der durch den auf den zweiten Leiter 8, beispielsweise den Draht 10, aufgebrachten Mantel 28 bedingt ist, und wodurch der Mantelaußendurchmesser m größer als der Durchmesser d des zweiten Leiters 8 ist. Beim Einschieben des zweiten Leiters 8 in Richtung des Richtungspfeils R in den Schlitz 4 wird von der bevorzugt scharfkantig ausgebildeten Abisolierstufe 25 der Mantel 28 durchtrennt beziehungsweise sein Mantelmaterial 29 verdrängt, sodass der zweite Leiter 8 blank liegt. Der zweite Leiter 8 wird dann weiter in Richtung des Richtungspfeils R in den Schlitz 4 in Richtung auf die Schlitzendwand 26 hinzu bewegt, wodurch es zum klemmenden Presssitz des zweiten Leiters 8 innerhalb des Schlitzes 4 zwischen den Schlitzwänden 9 kommt und die elektrische Kontaktierung bewirkt wird. Die Abisolierstufe 25 kann beispielsweise durch Ausstanzen, insbesondere schräges und/oder gratbildendes Ausstanzen, aus dem Basisteil 2 bewirkt werden.

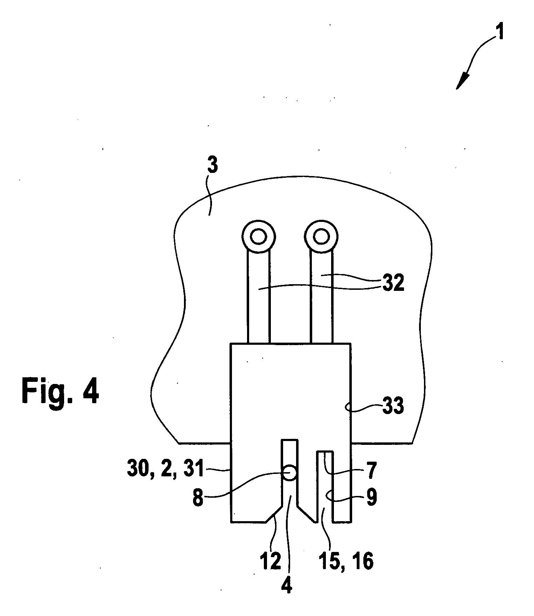

Figur 4 zeigt eine beispielhafte Ausbildung der Kontaktvorrichtung 1 mit einem als Kontaktvermittlungsteil 30 ausgebildeten Basisteil 2, wobei das Kontaktvermittlungsteil 30 ein Aufschiebekontaktmittel 31 ist. Dieses weist wiederum die Einführhilfe 12 zur Aufnahme des zweiten Leiters 8 in dem Schlitz 4 auf, sowie den Durchbruch 15 als randoffenen Durchbruch 16, der hier nur einseitig parallel zum Schlitz 4 ausgebildet ist. Selbstverständlich kann der Durchbruch 15 auch an anderer Stelle oder beidseitig des Schlitzes 4 angeordnet sein. Das Basisteil 2 ist hier als das Aufschiebekontaktmittel 31 ausgebildet, dergestalt, dass es auf eine von dem Basisteil 2 verschiedene Leiterplatte 3 zum Zwecke der Kontaktierung aufgeschoben wird. Die Leiterplatte 3 weist Leiterbahnen 32 auf, die mit hier nicht dargestellten Kontaktmitteln des Aufschiebekontaktmittels 31 korrespondieren, und die mit dem ersten Leiter 7 der an den Schlitzwänden 9 des Schlitzes 4 ausgebildet ist, elektrisch verbunden sind. Bevorzugt weist das Aufschiebekontaktmittel 31 hierzu einen im Wesentlichen quer zum Schlitz 4 und parallel zur Leiterplatte 3 verlaufenden Aufschiebeschlitz 33 auf, der hier aufgrund der Perspektive hier nicht sichtbar ist, und der der Aufnahme der Leiterplatte 3 und der elektrischen Kontaktierung der Kontaktmittel mit den Leiterbahnen 32, der Leiterplatte 3 dient. Dies erlaubt eine universelle Anwendung der vorstehend beschriebenen Kontaktvorrichtung 1 und insbesondere eine vielfältige Ausbildung von Aufschiebekontaktmitteln 31 und Kontaktvermittlungsteilen 30 in der Form von Adaptern zur Aufnahme von zweiten Leitern 8 und deren Kontaktierung mit Leiterplatten 3 oder ähnlichen Bauteilen.

## Patentansprüche

1. Kontaktvorrichtung zum elektrischen Kontaktieren von mindestens einem ersten Leiter mit mindestens einem zweiten Leiter, wobei der erste Leiter in einem Schlitzwände aufweisenden Schlitz eines Basisteils angeordnet ist und der zweite Leiter zur Kontaktierung des ersten Leiters in den Schlitz zur Erzeugung einer Schneidklemmverbindung eingedrückt ist, **dadurch gekennzeichnet, dass** das Basisteil (2) benachbart zum Schlitz (4) mindestens einen Durchbruch (15) zum federnden Nachgeben der zugeordneten Schlitzwand (26) des Schlitzes (4) aufweist.

2. Kontaktvorrichtung nach Anspruch 1, **dadurch gekennzeichnet, dass** der Durchbruch (15) ein schlitzförmiger Durchbruch (17) ist.

3. Kontaktvorrichtung nach einem der vorhergehenden Ansprüche, **dadurch gekennzeichnet, dass** der Schlitz (4) ein randoffener Schlitz (5) ist.

4. Kontaktvorrichtung nach einem der vorhergehenden Ansprüche, **dadurch gekennzeichnet, dass** der Durchbruch (15) ein geschlossener oder ein randoffener Durchbruch (16) ist.

5. Kontaktvorrichtung nach einem der vorhergehenden Ansprüche, **dadurch gekennzeichnet, dass** das Basisteil (2) eine Leiterplatte (3) ist.

6. Kontaktvorrichtung nach einem der vorhergehenden Ansprüche, **dadurch gekennzeichnet, dass** der zweite Leiter (8) ein Draht (10), insbesondere Volldraht oder eine Litze, ist.

7. Kontaktvorrichtung nach einem der vorhergehenden Ansprüche, **dadurch gekennzeichnet, dass** der erste Leiter (7) eine Durchkontaktierung (34) des Schlitzes (4) ist.

8. Kontaktvorrichtung nach einem der vorhergehenden Ansprüche, **dadurch gekennzeichnet, dass** beidseitig benachbart zum Schlitz (4) Durchbrüche (15) angeordnet sind.

9. Kontaktvorrichtung nach einem der vorhergehenden Ansprüche, **dadurch gekennzeichnet, dass** der Schlitz (4) einen Schlitzeingang aufweist, der als Schlitzverengung zur Erzeugung einer Einführhilfe (12) ausgebildet ist.

10. Kontaktvorrichtung nach Anspruch 6, **dadurch gekennzeichnet, dass** der Draht (10) ein isolierter Draht ist.

11. Kontaktvorrichtung nach einem der vorhergehenden Ansprüche, **dadurch gekennzeichnet, dass** der Schlitz (4) mindestens eine Abisolierstufe (25) aufweist.

12. Kontaktvorrichtung nach einem der vorhergehenden Ansprüche, **gekennzeichnet durch** eine den zweiten Leiter (8) aufnehmende Leiterfixierung (19).

13. Kontaktvorrichtung nach Anspruch 12, **dadurch gekennzeichnet, dass** die Leiterfixierung (19) als Gehäuse (20) einer elektrischen/elektronischen Einrichtung ausgebildet ist.

14. Kontaktvorrichtung nach einem der vorhergehenden Ansprüche, **dadurch gekennzeichnet, dass** das Basisteil (2) ein Kontaktvermittlungsteil (30) ist.

15. Kontaktvorrichtung nach einem der vorhergehenden Ansprüche, **dadurch gekennzeichnet, dass** das Basisteil (2) ein Aufschiebekontaktmittel (31) ist.

## Claims

1. Contact apparatus for at least one first conductor to make electrical contact with at least one second conductor, wherein the first conductor is arranged in a slot in a base part, which slot has slot walls, and the second conductor for making contact with the first conductor is pressed into the slot for the purpose of generating an insulation-displacement connection, **characterized in that** the base part (2) has, adjacent to the slot (4), at least one aperture (15) for resilient yielding of the associated slot wall (26) of the slot (4).

2. Contact apparatus according to Claim 1, **characterized in that** the aperture (15) is a slot-like aperture (17).

3. Contact apparatus according to either of the preceding claims, **characterized in that** the slot (4) is a slot (5) which is open at the edge.

4. Contact apparatus according to one of the preceding claims, **characterized in that** the aperture (15) is a closed aperture (16) or an aperture (16) which is open at the edge.

5. Contact apparatus according to one of the preceding claims, **characterized in that** the base part (2) is a printed circuit board (3).

6. Contact apparatus according to one of the preceding claims, **characterized in that** the second conductor (8) is a wire (10), in particular a solid wire or a litz wire.

7. Contact apparatus according to one of the preceding claims, **characterized in that** the first conductor (7) is a plated-through hole (34) in the slot (4).

8. Contact apparatus according to one of the preceding claims, **characterized in that** apertures (15) are arranged on both sides adjacent to the slot (4).

9. Contact apparatus according to one of the preceding claims, **characterized in that** the slot (4) has a slot inlet which is designed as a slot constriction for the purpose of generating an insertion aid (12).

10. Contact apparatus according to Claim 6, **characterized in that** the wire (10) is an insulated wire.

11. Contact apparatus according to one of the preceding claims, **characterized in that** the slot (4) has at least one insulation-stripping stage (25).

12. Contact apparatus according to one of the preceding claims, **characterized by** a conductor fixing means (19) which holds the second conductor (8).

13. Contact apparatus according to Claim 12, **characterized in that** the conductor fixing means (19) is designed as a housing (20) of an electrical/electronic device.

14. Contact apparatus according to one of the preceding claims, **characterized in that** the base part (2) is a contact-establishing part (30).

15. Contact apparatus according to one of the preceding claims, **characterized in that** the base part (2) is a push-on contact means (31).

## Revendications

1. Dispositif de contact destiné à établir un contact électrique entre au moins un premier conducteur et au moins un deuxième conducteur, le premier conducteur étant disposé dans une fente présentant des parois et ménagée dans une partie de base, le deuxième conducteur étant enfoncé dans la fente pour être mis en contact avec le premier conducteur et former une liaison par lames de contact,
**caractérisé en ce que**
au voisinage de la fente (4), la partie de base (2) présente au moins une perforation (15) qui permet à la paroi (26) associée à la fente (4) de se déformer élastiquement.

2. Dispositif de contact selon la revendication 1, **caractérisé en ce que** la perforation (15) est une perforation (17) en forme de fente.

3. Dispositif de contact selon l'une des revendications précédentes, **caractérisé en ce que** la fente (4) est une fente (5) à bords ouverts.

4. Dispositif de contact selon l'une des revendications précédentes, **caractérisé en ce que** la perforation (15) est une perforation (16) ouverte ou à bords ouverts.

5. Dispositif de contact selon l'une des revendications précédentes, **caractérisé en ce que** la partie de base (2) est une carte de circuit (3).

6. Dispositif de contact selon l'une des revendications précédentes, **caractérisé en ce que** le deuxième conducteur (8) est un fil (10) et en particulier un fil plein ou une tresse.

7. Dispositif de contact selon l'une des revendications précédentes, **caractérisé en ce que** le premier conducteur (7) est une perforation de contact (34) de la fente (4).

8. Dispositif de contact selon l'une des revendications précédentes, **caractérisé en ce que** des perforations (15) sont disposées au voisinage des deux côtés de la fente (4).

9. Dispositif de contact selon l'une des revendications précédentes, **caractérisé en ce que** la fente (4) présente une entrée configurée comme rétrécissement permettant de former un accessoire d'insertion (12).

10. Dispositif de contact selon la revendication 6, **caractérisé en ce que** le fil (10) est un fil isolé.

11. Dispositif de contact selon l'une des revendications précédentes, **caractérisé en ce que** la fente (4) présente au moins un étage d'isolation (25).

12. Dispositif de contact selon l'une des revendications précédentes, **caractérisé par** une fixation (19) qui reprend le deuxième conducteur (8).

13. Dispositif de contact selon la revendication 12, **caractérisé en ce que** la fixation (19) est configurée comme boîtier (20) d'un dispositif électrique ou électronique.

14. Dispositif de contact selon l'une des revendications précédentes, **caractérisé en ce que** la partie de base (2) est une partie de mise en contact (30).

15. Dispositif de contact selon l'une des revendications précédentes, **caractérisé en ce que** la partie de base (2) est un moyen coulissant de contact (31).
